Europäisches Patentamt

European Patent Office

Office européen des brevets

(19)

(11) Numéro de publication : **0 030 878**
**B1**

(12) FASCICULE DE BREVET EUROPÉEN

(45) Date de publication du fascicule du brevet :
30.01.85

(51) Int. Cl.⁴ : **G 03 B 41/00**

(21) Numéro de dépôt : **80401675.6**

(22) Date de dépôt : **21.11.80**

(54) **Système optique d'alignement de deux motifs et photorépéteur mettant en oeuvre un tel système.**

(30) Priorité : **18.12.79 FR 7930935**

(43) Date de publication de la demande :
**24.06.81 Bulletin 81/25**

(45) Mention de la délivrance du brevet :
**30.01.85 Bulletin 85/05**

(84) Etats contractants désignés :
**CH DE GB IT LI NL SE**

(56) Documents cités :
**EP-A- 0 015 173**
**US-A- 3 718 396**

(73) Titulaire : **THOMSON-CSF**
**173, Boulevard Haussmann**
**F-75379 Paris Cedex 08 (FR)**

(72) Inventeur : **Lacombat, Michel**
**THOMSON-CSF - SCPI 173, Bld Haussmann**
**F-75360 Paris Cedex 08 (FR)**

(74) Mandataire : **Lepercque, Jean et al**
**THOMSON-CSF SCPI 173, Bld Haussmann**
**F-75379 Paris Cedex 08 (FR)**

Jouve, 18, rue St-Denis, 75001 Paris, France

## Description

L'invention se rapporte à un système optique d'alignement de deux motifs utilisant un troisième motif ou motif intermédiaire de référence, et notamment à un photorépéteur mettant en œuvre ce système optique d'alignement pour le positionnement d'une plaquette semi-conductrice suivant deux axes de référence.

La fabrication de circuits intégrés implique la réalisation sur un substrat de fenêtres permettant de localiser l'implantation ou le traitement. Ce substrat est recouvert d'une couche de résine photosensible. La réalisation de fenêtres se fait par masquage de cette résine à partir d'un masque porté par un réticule. Antérieurement, il a été utilisé comme méthode de transfert le contact direct ou la proximité. Les procédés actuels mettent en œuvre la technique de transfert par projection optique.

Cette projection peut être effectuée au rapport 1/1, et le masque est globalement projeté sur la plaquette. Cette projection peut également être effectuée par partition de l'image : soit par analyse du masque par une fente mobile, soit par utilisation de la technique de photorépétition au rapport 1/n.

Dans la technique de fabrication de circuits par photorépétition directe, chaque motif à réaliser est projeté directement sur la plaquette semi-conductrice préalablement recouverte d'une couche de résine photosensible, suivant un programme préétabli, la position de la plaquette étant contrôlée par interférométrie suivant deux directions X et Y. De manière classique, la photorépétition est effectuée en décalant la plaquette suivant deux directions X et Y orthogonales entre elles.

Dans tous les cas on doit positionner, l'un par rapport à l'autre et de façon très précise, le réticule et la plaquette en matériau semi-conducteur sur laquelle doit être réalisé le circuit intégré. Pour ce faire, de nombreux procédés d'alignement ont été proposés. En général, il est fait appel à des motifs supplémentaires comprenant des repères d'alignement portés par le réticule et par la plaquette semi-conductrice. Selon le procédé mis en œuvre, le nombre de ces repères, leur disposition ou leur configuration doivent être tels qu'ils permettent l'alignement selon deux axes de référence X, Y et éventuellement l'alignement angulaire de la plaquette semi-conductrice. On peut distinguer essentiellement deux approches pour obtenir l'alignement désiré.

Selon une première approche, l'alignement est réalisé en mettant en coïncidence directe les repères d'alignement portés sur le réticule et la plaquette semi-conductrice ou leur projection. Cette première approche soulève un certain nombre de difficultés qui vont être exposées dans ce qui suit. Il est bien connu que la résine est sensible à une gamme étroite de longueurs d'onde. La source utilisée pour l'exposition du motif à projeter sur la plaquette semi-conductrice, c'est-à-dire pendant l'insolation de la résine, est soit une source à spectre étroit, comme par exemple un laser, soit une source à plus large spectre associée à des filtres. Si on utilise une source unique pour les opérations d'alignement et d'insolation de la résine, ou si plus généralement deux sources distinctes de même longueur d'onde sont utilisées, il faut veiller à ce que les repères d'alignement et les motifs à projeter soit illuminés uniquement pendant les phases concernées, c'est-à-dire respectivement pendant la phase d'alignement et la phase d'exposition. Il est alors nécessaire de faire intervenir des caches positionnés avec précision, les repères d'alignement et le motif à projeter étant très proches les uns des autres. Par ailleurs, si le système d'éclairement des repères d'alignement est distinct de celui de l'exposition, le premier système doit être escamoté pendant la phase d'exposition. Si on utilise une longueur d'onde d'alignement distincte de celle de l'exposition, il faut alors introduire pendant la phase d'alignement des lentilles ou plus généralement un système de correction, avec une grande précision de positionnement. Ces lentilles ou ce système de correction doivent être également escamotés pendant la phase d'exposition. Il faut en outre commuter le (ou les) systèmes(s) de détection nécessaire à l'alignement, ce système étant par exemple mis en place dans la pupille de l'objectif utilisé pour l'exposition.

Selon une seconde approche, des repères d'alignement intermédiaires sont utilisés. Selon cette approche, l'alignement, l'un par rapport à l'autre, du réticule et de la plaquette semi-conductrice ne se fait plus directement par mise en coïncidence des repères d'alignement ou de leur projection, mais séquentiellement par utilisation de repères d'alignement intermédiaires.

Un système selon la seconde approche, dans lequel l'alignement peut s'effectuer par l'utilisation de moyens intermédiaires formant repères d'alignement est décrit dans le brevet US-A-3 718 396. Ce brevet divulgue notamment par les variantes décrites en relation avec les figures 14 à 16, un système d'alignement X-Y automatique d'une plaquette semi-conductrice mobile par rapport à un réticule mobile, par projection et centrage successifs de repères d'alignement respectivement portés par ledit réticule et ladite plaquette sur quatre éléments d'une cellule photodétectrice formant référence montée dans un microscope maintenu immobilisé ou fixe durant le processus d'alignement.

Cependant, selon l'enseignement de ce brevet, les moyens formant repères d'alignement intermédiaires, sont constitués non par des motifs liés mécaniquement à la machine mais sont constitués par des cellules photodétectrices liées à un microscope utilisé dans le système aux fins d'alignement.

Bien qu'obviant à toutes ou partie des difficultés qui viennent d'être rappelées et qui sont spécifiques à la première approche, les procédés de l'art connu selon la seconde approche sont complexes et multiplient le nombre d'étages intermédiaires nécessaires pour obtenir l'alignement désiré. La multiplication du nombre d'étapes, notamment, introduit corrélativement la multiplication des risques d'erreurs et diminue la précision de l'alignement.

Tout en appartenant à cette seconde approche, et pour en pallier les inconvénients, l'invention a donc pour objet un système optique d'alignement tel que défini par la revendication 1.

L'invention a également pour objet un photorépéteur mettant en œuvre un tel système optique d'alignement, tel que défini par les revendications 9 à 11.

L'invention sera mieux comprise et d'autres caractéristiques et avantages apparaîtront à la lecture de la description qui suit en référence aux figures annexées, parmi lesquelles :

les figures 1 à 3 illustrent une première variante de système optique d'alignement selon l'invention ;

les figures 4 à 7 illustrent plus en détail des éléments de l'invention ;

la figure 8 illustre de façon plus détaillée une des phases de l'alignement selon l'invention ;

les figures 9 et 10 illustrent de façon plus détaillée une autre phase de l'alignement selon l'invention ;

les figures 11 à 13 illustrent les phases de l'alignement d'une plaquette semi-conductrice par rapport à un réticule selon une deuxième variante de l'invention ;

la figure 14 illustre un aspect particulier des première et deuxième variantes de l'invention ;

la figure 15 illustre une des phases de l'alignement d'une plaquette semi-conductrice par rapport à un réticule selon une troisième variante de l'invention.

Dans ce qui suit, les éléments communs à deux figures ou plus portent la même référence et ne seront décrits qu'une seule fois. D'autre part, l'invention sera illustrée, sans que cela soit limitatif, par un système optique d'alignement mis en œuvre dans un appareillage de transfert par photorépétition directe sur silicium. Cet appareillage sera appelé plus brièvement photorépéteur.

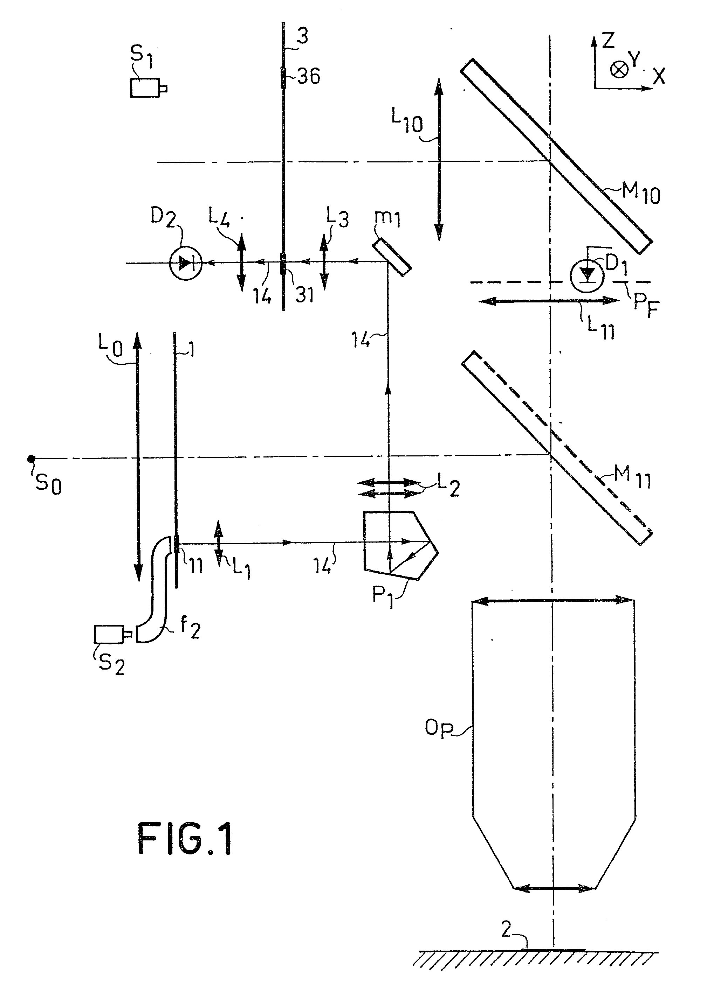

Une première variante d'un système optique d'alignement de deux motifs selon l''invention va être décrite au regard des figures 1 à 3.

La figure 1 illustre schématiquement la première phase nécessaire à l'alignement de deux motis, et plus spécifiquement selon l'invention, à l'alignement suivant deux axes de référence X et Y de repères d'alignement portés respectivement par un réticule et une plaquette semi-conductrice. Sur la figure 1, ainsi que sur les figures suivantes, seuls les constituants d'un photorépéteur indispensables à la compréhension de la présente invention ont été représentés. Les autres éléments constituant un photorépéteur sont connus de l'homme de métier et ne font pas partie du cadre de l'invention.

Comme il a été rappelé, la réalisation d'un circuit intégré sur une plaquette semi-conductrice comprend une étape consistant en la projection d'un ou plusieurs motifs, portés par un ou plusieurs réticules, sur cette plaquette semi-conductrice. Il est également connu que ces opérations nécessitent des étapes préliminaires ou intermédiaires d'alignement de la plaquette semi-conductrice par rapport au réticule. Pour ce faire, il est également connu de porter respectivement sur le réticule (outre les motifs à projeter) et sur la plaquette semi-conductrice, des motifs supplémentaires constitués de repères d'alignement. Ces repères sont en général au moins au nombre de deux, ce qui permet un alignement suivant deux axes coordonnées X, Y. Pour effectuer l'alignement, il est d'usage de projeter les repères portés par le réticule sur la plaquette semi-conductrice et l'alignement est obtenu lorsque la projection des repères portés par le réticule coïncident avec les repères correspondants portés par la plaquette semi-conductrice.

Selon une première approche, l'alignement de ces deux couples de repères s'effectue directement, selon une seconde approche, à laquelle appartient l'invention, l'alignement s'effectue à l'aide de repères intermédiaires. Le fonctionnement d'un système optique d'alignement mettant en œuvre un tel procédé est donc du type séquentiel, c'est-à-dire que l'alignement final est réalisé après plusieurs phases d'alignement intermédiaires. L'invention propose un système optique d'alignement mettant en œuvre un procédé d'alignement faisant usage d'un motif intermédiaire et ne nécessitant qu'un nombre réduit de phases d'alignement intermédiaires tout en autorisant une grande précision dans l'alignement.

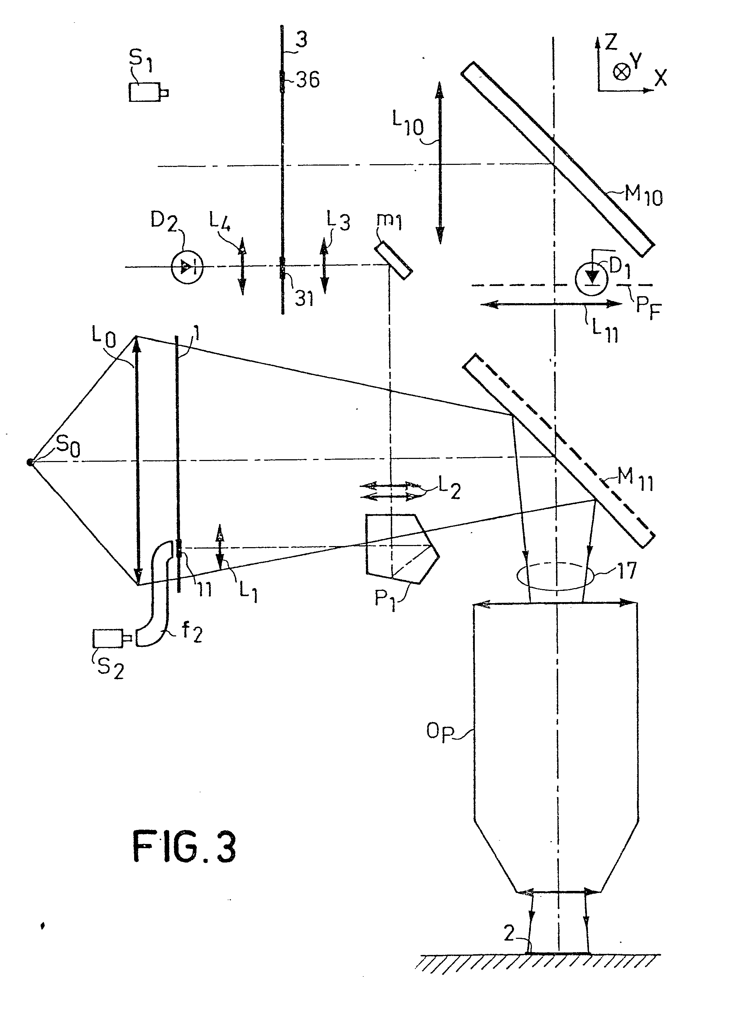

Les éléments constitutifs principaux d'un photorépéteur vont tout d'abord être rappelés. Dans un photorépéteur, par exemple celui illustré schématiquement sur les figures 1 à 3, un motif porté par un réticule 1 doit être projeté, à l'aide d'un objectif de projection $O_p$, sur une plaquette semi-conductrice 2. Selon l'invention, il est fait usage d'un miroir intermédiaire $M_{11}$ repliant sur lui-même le faisceau de projection 17 (figure 3).

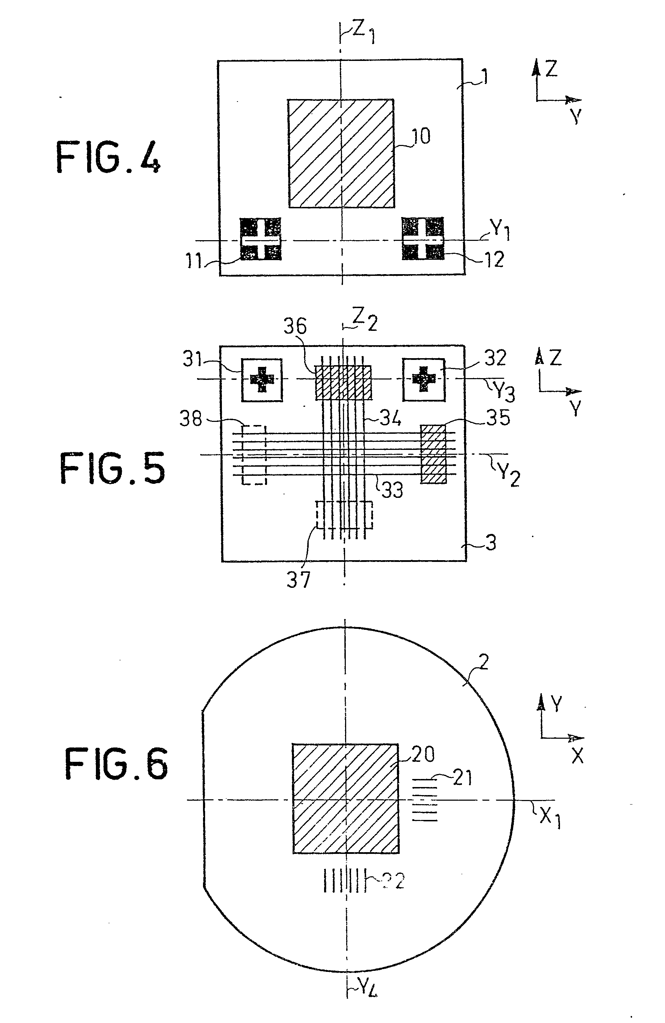

Le réticule 1 est illustré de façon plus détaillée par la figure 4. Ce réticule comprend une zone centrale 10 portant le motif à projeter et un couple de repères d'alignement constitués par des motifs supplémentaires 11 et 12 alignés sur un axe $Y_1$ parallèle à l'axe de référence Y. Ces deux derniers repères 11 et 12 sont situés symétriquement par rapport à un axe de symétrie $Z_1$ et de part et d'autre du motif 10.

La plaquette semi-conductrice 2 est illustrée de manière plus détaillée par la figure 6. Le motif 10 du réticule 1 va être projeté en 20 sur la plaquette semi-conductrice 2. Cette plaquette comporte également un couple de repères d'alignement constitué par les motifs 21 et 22 situés respectivement sur des axes de symétrie $X_1$ et $Y_4$ et disposés en périphérie de la zone 20. Les axes $X_1$ et $Y_4$ sont respectivement parallèles aux axes de référence X et Y.

Selon l'invention, le réticule 1 mobile va tout d'abord être aligné par rapport à des repères intermédiaires liés à la machine. Pour ce faire on utilise un réticule supplémentaire 3 portant des couples de repères complémentaires à ceux portés par le réticule 1 et la plaquette 2, et fixe par rapport au chassis du photorépéteur. Ce réticule 3 est illustré de manière plus détaillée par la figure 5. Il comporte, alignés sur un axe $Y_3$ parallèle à l'axe de référence Y, de part et d'autre d'un axe de symétrie en $Z_2$, deux repères d'alignement constitués par les motifs 31 et 32 complémentaires aux motifs 11 et 12 du réticule 1. La distance séparant ces deux motifs 31 et 32 est égale à la distance séparant les centres des motifs 11 et 12. Il comporte également des motifs 33 et 34 servant de repères d'alignement par rapport aux repères 21, 22 de la plaquette semi-conductrice.

La figure 1 illustre la première phase de l'alignement. Cet alignement peut mettre en œuvre différents procédés de l'art connu. A titre d'exemple non limitatif, on peut citer les procédés décrits dans les publications suivantes : publication américaine « Applied Physics Letters », vol. 31, n° 7, 10 Octobre 1977, pages 426 à 428 ; publication française « Revue Technique THOMSON-CSF », vol. 10, n° 4, Décembre 1978, pages 733 à 755 ; demande de brevet français n° 77 11 908, déposée le 20 Avril 1977 et publiée sous le n° 2 388 371 ; et la demande de brevet Européen publiée sous le n° EP-A1-00 15 173 le 3 Septembre 1980 (cette dernière demande appartenant à l'état de la technique tel que visé à l'article 54 (3) de la C.B.E.).

Dans ce qui suit, et pour fixer les idées, on suppose que, d'une part le couple de repères 31-32 lié à la machine et, d'autre part le couple de repères 11 et 12 portés par le réticule 1 sont constitués par des croix optiquement complémentaires. Le réticule 3, fixe, est disposé dans le photorépéteur de telle façon que l'axe $Y_3$ joignant le centre des repères 31 et 32 sont parallèle à l'un des axes de translation de la table qui, comme il est connu, supporte la plaquette semi-conductrice, ce avec une précision d'une seconde d'arc. Dans l'exemple choisi, cet axe $Y_3$ est parallèle à l'axe Y. On éclaire les zones portant les repères d'alignement 11 et 12 à l'aide par exemple d'un endoscope à fibres optiques $f_2$ projetant sur ces repères un faisceau lumineux produit par une source $S_2$. Cette source $S_2$ peut être constituée par un laser ; notamment un laser He Ne de longueur d'onde 6 328 Å. L'image du repère 11, par exemple, est projetée à l'aide du système optique comprenant des lentilles $L_1$ à $L_3$ ainsi que le prisme à double réflexion $P_1$ et le miroir $m_1$. L'ensemble de ce système optique est équivalent à un objectif de projection de grandissement + 1. La coïncidence des repères 11 et 31 est détectée par un dispositif optoélectronique schématisé sur la figure 1 par la diode $D_2$ et la lentille convergente $L_4$. La marche des rayons lumineux figure sous la référence 14.

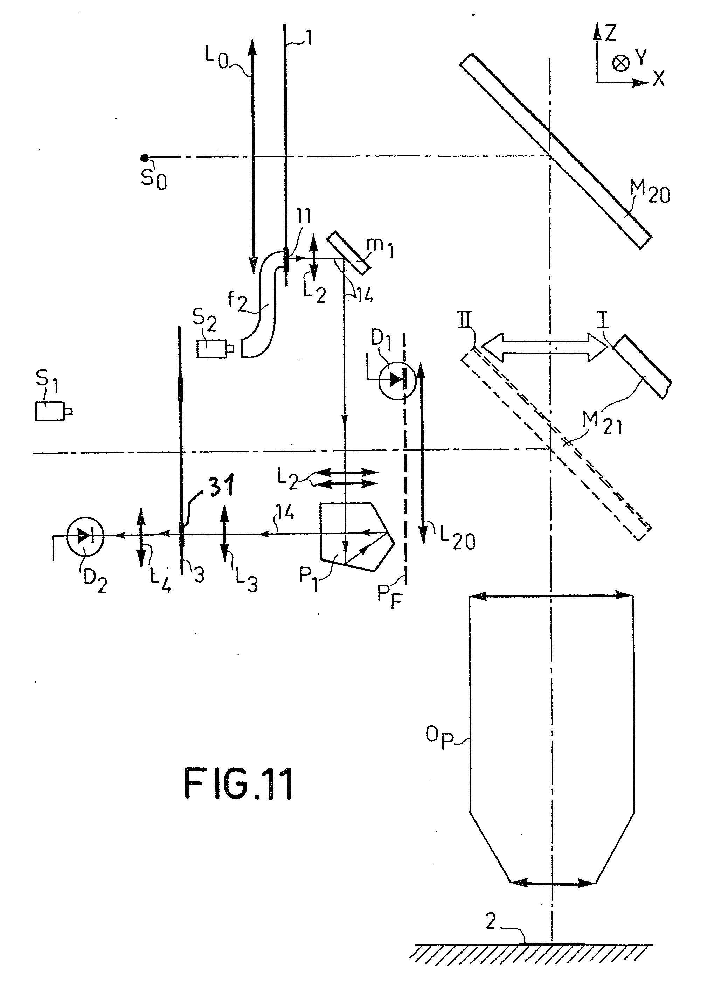

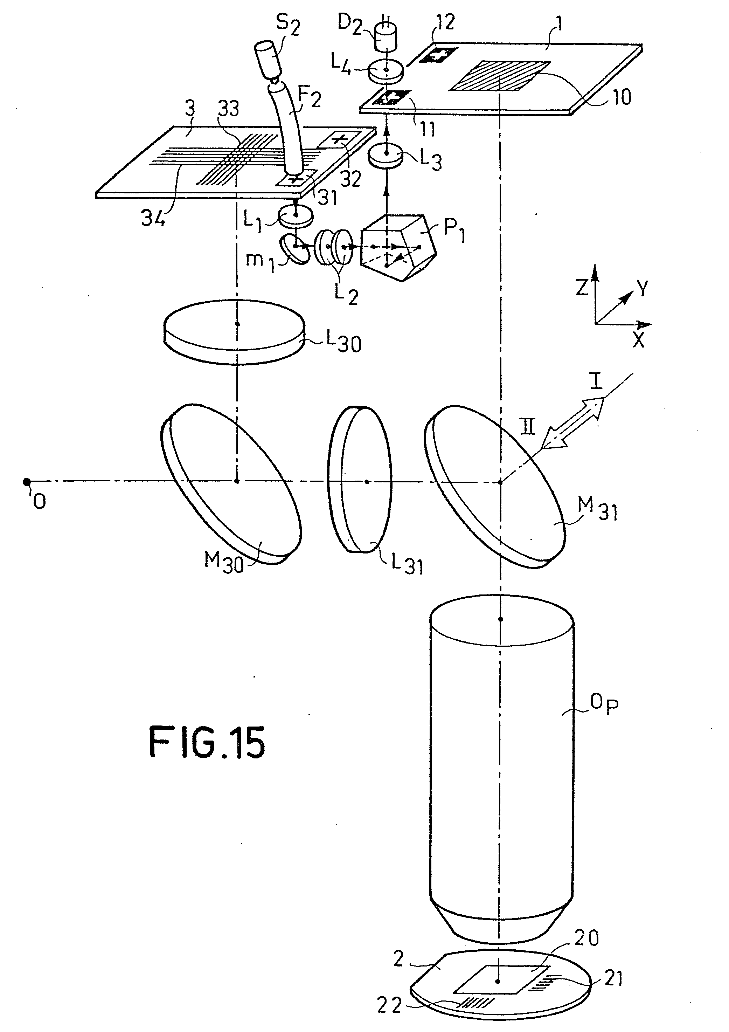

Dans la réalité, en plus de l'alignement selon deux axes de coordonnées, respectivement Y et Z sur la figure 1, le réticule doit être positionné également angulairement. Pour ce faire, le procédé décrit dans la demande de brevet français n° 77 11 908 précitée peut être utilisé. Les figures 9 et 10 illustrent de façon plus détaillée deux étapes de la phase d'alignement des couples de repères respectivement 11-12 et 31-32. Lors de cette phase d'alignement, les signaux détectés par les moyens optoélectroniques $D_2$ sont exploités par des circuits électroniques associés, non décrits. Ces circuits sont bien connus de l'homme de métier et sortent du cadre de la présente invention. Il est à noter que les positions relatives de la source $S_2$ et des moyens optoélectroniques $D_2$ sont indifférentes : le trajet des rayons 14 peut être inversé. Un exemple d'une telle disposition sera décrit ultérieurement en relation avec la figure 15. Bien que sur la figure 1 seul ait été représenté l'alignement du repère 31 par rapport au repère 11, il va de soit qu'un système optique de grandissement + 1 ainsi qu'une source d'énergie lumineuse et des moyens optoélectroniques de détection sont également associés au couple de repères à aligner 12 et 32.

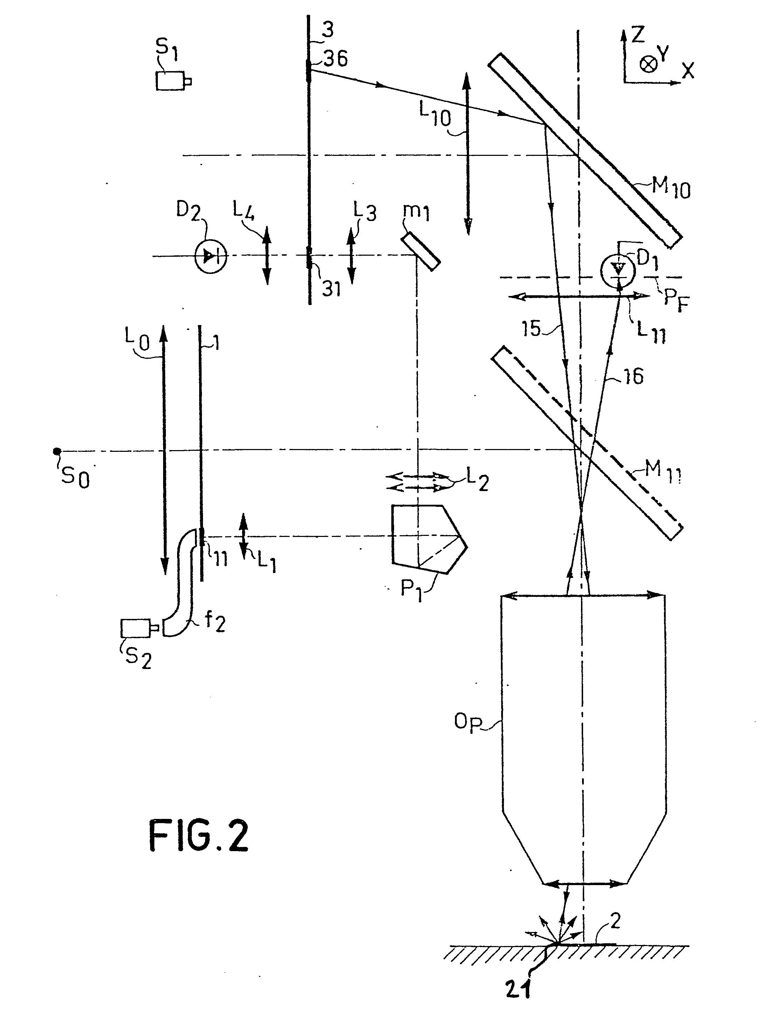

Une fois le positionnement précis du réticule 1 portant le motif à projeter par rapport à des références machine obtenu, la seconde phase d'alignement selon l'invention consiste à positionner également de façon précise la plaquette semi-conductrice 2 par rapport au réticule 3 portant les repères machine. Cette seconde phase de l'alignement est illustrée par la figure 2. Outre les repères 31 et 32, le réticule 3 lié à la machine (et illustré par la figure 5) comporte également une autre série de repères, référencés 33 et 34, qui vont être utilisés pendant cette seconde phase d'alignement.

Ces repères 33, 34 sont du type réseau optique. De tels réseaux ont été décrits dans la demande de brevet Européen EP-A-15 173 précitée. S'il est en effet aisé de déterminer avec précision le niveau du contraste des repères portés sur les réticules et ce, de façon constante d'un réticule à l'autre, il n'est pas facile d'obtenir ce même résultat avec les repères portés par la plaquette semi-conductrice. Le contraste des repères sur le silicium est très variable d'un niveau d'intégration à l'autre, compte-tenu des variations d'épaisseur d'oxyde ou de la nature des dépôts (silicium polycristallin, aluminium). La qualité de l'alignement sera donc essentiellement variable. Elle dépend soit de l'acuité visuelle de l'opérateur dans le cas du procédé manuel d'alignement, soit du pouvoir de résolution de l'électronique associée lorsque l'alignement est automatique. Dans ce qui suit le positionnement de la plaquette semi-conductrice par rapport aux repères liés à la machine se fera selon le procédé décrit dans cette demande EP-A-15 173 précitée qui pallie ces inconvénients.

Pour ce faire, une partie des motifs sous forme de réseaux 33 et 34, partie délimitée par des fenêtres, par exemple les fenêtres 35 et 36 (figure 5), va être projetée sur les repères d'alignement corespondants 21 et 22 de la plaquette semiconductrice 2, repères illustrés par la figure 6. Ces repères sont disposés de part et d'autre du motif projeté 20, suivant deux axes $X_1$ et $Y_4$ respectivement parallèles aux axes de références X et Y.

Sur la figure 2, les repères 35 et 36 illuminés par une source cohérente d'énergie radiante $S_1$ sont projetés par l'intermédiaire d'un système optique comprenant des lentilles $L_{10}$, $L_{11}$, le miroir $M_{10}$ et une lame $M_{11}$ faisant office de miroir partiellement réfléchissant ainsi que l'objectif de projection $O_p$, sur la plaquette semi-conductrice 2. Les fenêtres 35 et 36 sont positionnées sur le réticule 3 de façon à correspondre à travers l'optique complète aux repères 21-22 de la plaquette semiconductrice. Leur position dépend de la taille du circuit vu à travers l'optique $O_p$, ces fenêtres 35 et 36 peuvent être déplacées sur le réticule 3 suivant les axes $Z_2$ et $Y_2$ pour s'adapter à l'écartement et à la position des motifs 21 et 22.

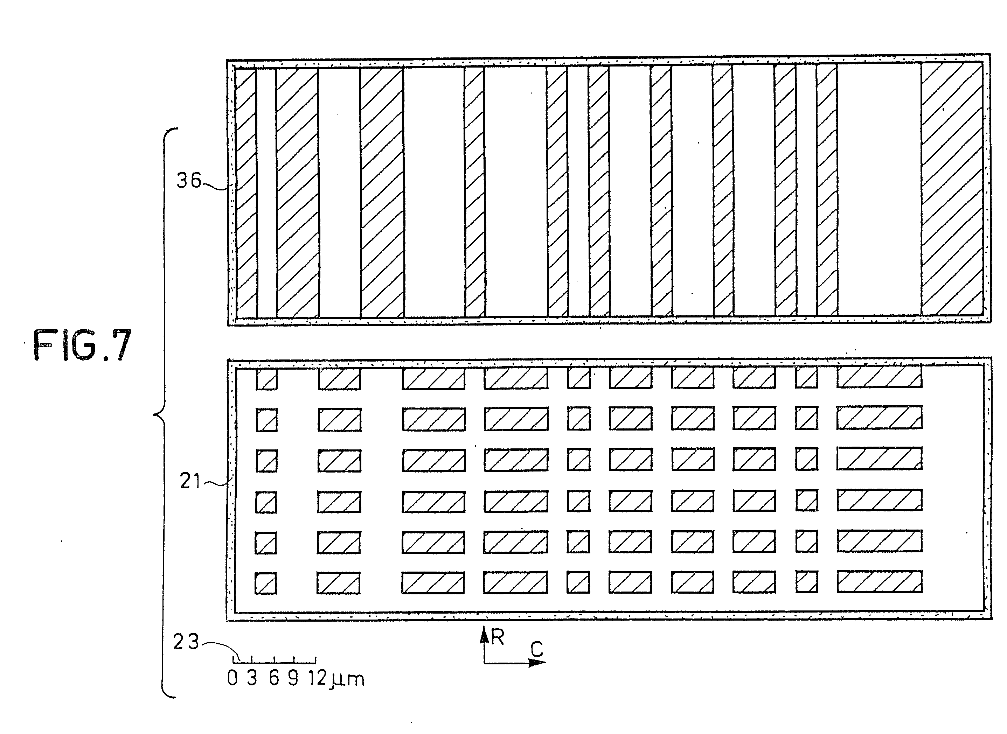

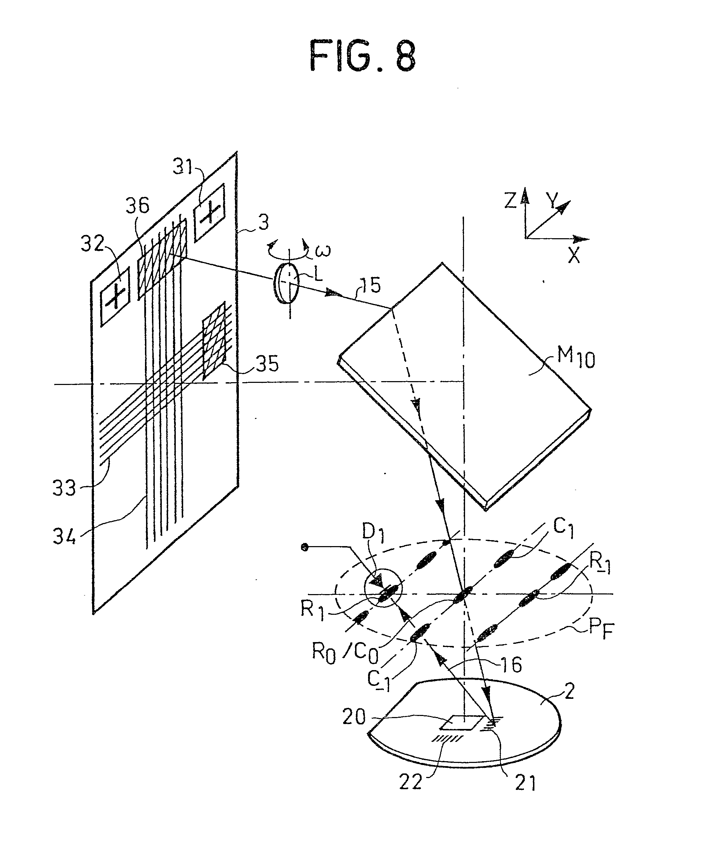

Il est utile tout d'abord de rappeler l'essentiel du procédé décrit dans la demande de brevet EP-A-15 173 précitée. La mise en œuvre de ce procédé dans le cadre spécifique de l'invention est illustré schématiquement en référence à la figure 8. Un premier motif constitué par deux réseaux optiques 21-22, disposés suivant deux axes de coordonnées, X et Y dans le cadre de l'exemple choisi, est éclairé par l'image d'un second motif comprenant deux réseaux optiques 35-36, formant référence, et produit des ordres de diffraction. Les deux réseaux 35-36 sont disposés suivant deux axes Z et Y. Le faisceau de rayons d'alignement 15 est replié sur lui-même par le miroir $M_{10}$. L'optique de projection $O_p$ a été omise sur la figure 8. Le type de réseau optique utilisable est illustré par la figure 7. Ces réseaux optiques sont constitués d'une suite de traits parallèles dont l'épaisseur de la répartition spatiale suivant une direction C est déterminée par un code pseudoaléatoire. La partie supérieure de la figure 7 illustre le réseau délimité par la fenêtre 36. Les réseaux délimités par la fenêtre 35 ou les fenêtres 37 et 38 sont identiques. Le réseau de la partie inférieure de la figure 7 illustre le réseau 21 porté par la plaquette semi-conductrice. Ce réseau est identique au réseau 22. Ce réseau est identique optiquement au réseau porté par le réticule 3 lié à la machine. Les traits de ce réseau sont en outre interrompus périodiquement suivant une direction R pour former un réseau à pas constant ; les directions R et C étant orthogonales entre elles et parallèles chacune à un des axes de référence X ou Y.

L'image du réseau 36 est projetée sur le réseau 21 porté par la plaquette semi-conductrice 2. La source d'illumination $S_1$ peut être également un laser He Ne identique à celui de la source $S_p$. La dimension du réseau optique 36 est telle qu'il puisse être superposé au réseau 21 suivant la direction C, compte tenu du grandissement des moyens optiques. A titre indicatif, les dimensions du réseau peuvent être déduites de l'échelle 23 (Fig. 7). Le réseau 21, éclairé par l'image du réseau 36, va produire des ordres de diffraction suivant les directions C et R ou ce qui revient au même, suivant les directions X et Y. Les ordres de diffraction suivant des directions 16 vont pouvoir être détectés dans le plan Fourier $P_F$. Ce plan de Fourier est situé dans l'image de la pupille de l'objectif de projection $O_P$ (non représenté sur la figure 8). On a représenté dans ce plan les ordres de diffraction $C_0$, $C_1$, $C_{-1}$ suivant la direction parallèle à l'axe de référence Y et les ordres $R_0$, $R_1$, et $R_{-1}$ suivant la direction parallèle à l'axe de référence X. L'ordre de diffraction $R_1$ est détecté par un moyen optoélectronique symbolisé par la diode $D_1$. Les signaux de sortie de ces moyens optoélectroniques $D_1$ sont transmis à des moyens électroniques appropriés, non représentés. L'intensité des rayons diffractés 16 est alors modulée en amplitude et cette modulation facilite l'exploitation des signaux délivrés par des moyens optoélectroniques $D_1$, en vue de l'asservissement automatique de la position dans le plan XY de la plaquette semi-conductrice. Cette plaquette est solidaire d'une table de translation animée d'un mouvement suivant deux axes X et Y, ce à l'aide de moteurs recevant des signaux d'asservissement issus du traitement, par des circuits électroniques, des signaux détectés par les moyens optoélectroniques d'alignement. Ces techniques sont bien connues de l'homme de métier et ne seront pas décrites plus avant. A titre de variante parmi d'autres, la modulation du signal détecté peut être aussi obtenue par une faible modulation de la position X Y de la plaquette semiconductrice (de l'ordre de quelques dizaines de $\mu$m).

On a ainsi aligné un circuit, ou puce, de la plaquette semi-conductrice. Ce circuit est symbolisé par la zone 20 de la figure 6. En réalité, cette zone 20 est répétée un certain nombre de fois le long de lignes et colonnes. La dimension des repères 21 et 22 étant très faible, il est nécessaire d'aligner au moins deux circuits disposés à deux endroits diamétralement opposés de la plaquette et situés en périphérie pour obtenir un alignement angulaire de la plaquette semi-conductrice. Cet alignement peut nécessiter des opérations itératives.

La figure 3 illustre une phase ultérieure pendant laquelle la plaquette semi-conductrice 2 est insolée, c'est-à-dire pendant le transfert. Pour ce faire, le motif délimité par la fenêtre 10 du réticule 1 (figure 4) est projeté sur la plaquette semiconductrice en 20 (figure 6). La source d'énergie lumineuse $S_0$ peut être constituée par une lampe au mercure, associée à des filtres de raies non représentés et à un condensateur $L_0$. Le faisceau de projection 17 est réfléchi par la lame $M_{11}$ formant miroir partiellement réfléchissant et passe au travers de l'optique de projection $O_p$ avant d'atteindre la plaquette semi-conductrice 2. Il est à noter que ce faisceau de projection n'interfère pas avec les systèmes optiques associés aux repères d'alignement 11 et 12. En effet, ces repères sont situés de part et d'autre de la fenêtre 10 comme illustré sur la figure 4 et peuvent donc être laissés en place pendant la phase d'exposition.

Les lentilles $L_{10}$ et $L_{11}$ constituent une optique de correction destinée à compenser les différences de longueur d'onde entre l'alignement et le transfert, ainsi que les aberrations introduites à la traversée de la lame $M_{11}$.

Les seules exigences en ce qui concerne le miroir $M_{10}$ sont qu'il ait une planéité suffisante de l'ordre de $\lambda/10$. Il est également de préférence traité en monocouche ou multicouche pour éviter une variation du coefficient de réflexion.

La lame semi-réfléchissante $M_{11}$ est constituée par un miroir multidiélectrique. Son coefficient de réflexion peut être de 0,99 dans la gamme $4\,050\ \text{Å} < \lambda < 4\,350\ \text{Å}$ (selon la longueur d'onde retenue pour l'insolation) et son coefficient de transmission de l'ordre de 0,5 pour $\lambda = 6\,328\ \text{Å}$, si cette longueur d'onde est retenue pour l'alignement (laser He Ne), ou pour toute autre longueur d'onde. L'objectif de projection $O_P$ est corrigé pour la longueur d'onde retenue pour la projection (ou transfert). Comme il a été indiqué, la source d'énergie lumineuse $S_0$ peut être une lampe au mercure à spectre étendu. Une raie particulière est sélectionnée à l'aide d'un filtre, par exemple la raie $\lambda = 4\,050\ \text{Å}$. Cette valeur doit correspondre à la sensibilité maximum de la résine photosensible déposée sur la plaquette semi-conductrice. L'objectif de projection peut être, par exemple, un objectif de la marque CERCO du type 744 doté d'un rapport de réduction $1/5$. Les moyens de détection optoélectroniques peuvent être, soit des photodiodes (par exemple de la marque EGG, type SGD 100 ou HAD 1 000 A) ou un photo-multiplicateur (par exemple de la marque RTC, type XP 117). Les autres composants (lentilles, prismes, etc.) peuvent être choisis parmi ceux habituellement utilisés pour les photorépéteurs de l'art connu, notamment en ce qui concerne les tables mobiles portant le réticule 1 et la plaquette semi-conductrice 2.

Enfin, le miroir $M_{10}$ peut être également du même type que le miroir $M_{11}$, ce qui permet d'observer, par exemple à l'aide d'une caméra de télévision non représentée, le résultat de l'alignement, ce en simultanéité complète.

On peut également n'utiliser qu'une seule source d'énergie radiante commune aux deux phases d'alignement et d'exposition. Pendant les phases d'alignement, la source est diaphragmée fortement de manière à ce qu'on obtienne un éclairement quasi-cohérent et de faible intensité. La faible intensité de la lumière limite les risques d'insolation, la longueur d'onde étant celle pour laquelle la résine est sensible.

Une seconde variante d'exécution du système optique d'alignement selon l'invention va maintenant être décrite au regard des figures 11 à 13. Dans cette variante, on retrouve les éléments essentiels de l'invention :

— correspondance de l'échelle + 1 entre les repères d'alignement portés par le réticule 1 et les repères d'alignement liés à la machine, repères utilisés pendant la première phase de l'alignement ;

— utilisation de réseaux optiques codés pendant la seconde phase d'alignement des repères portés par la plaquette de silicium 2 et des repères également liés à la machine.

Les éléments des figures 11 à 13 portant les mêmes références que ceux des figures 1 à 3 sont identiques et ne seront plus décrits. La seconde variante d'exécution de l'invention diffère de la première par les points suivants :

— les positions respectives du réticule 1 et du réticule 3 sont inversées ;

— le miroir $M_{21}$ est un miroir commutable dans le plan de référence XY suivant un des axes X ou Y. Dans l'exemple décrit en relation avec les figures 11 à 13, ce miroir peut se déplacer entre les positions I et II suivant l'axe X.

Pendant la première phase de l'alignement (figure 11), le réticule 1 est positionné de façon précise, ce en mettant en œuvre un procédé analogue à celui décrit au regard de la figure 1. Pendant cette phase, bien que le miroir $M_{21}$ soit représenté sur la figure 11 en position I, la position du miroir $M_{21}$ est indifférente.

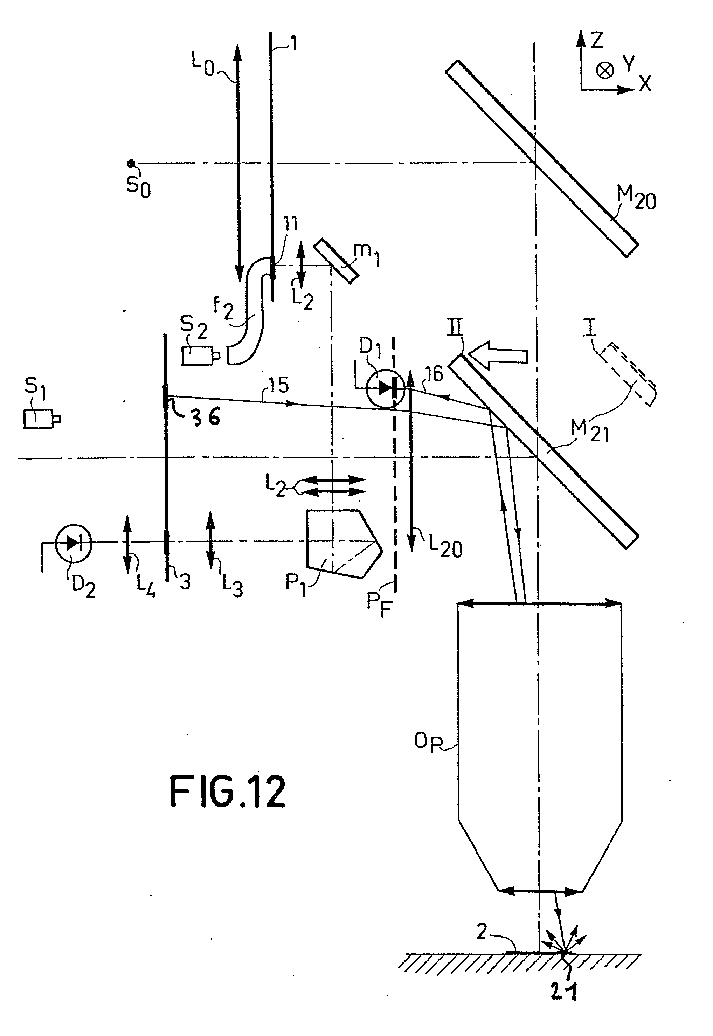

Pendant la seconde phase de l'alignement (figure 12), la plaquette semiconductrice 2 est à son tour positionnée de façon précise, ce, en mettant en œuvre le procédé décrit en relation avec la figure 2. Il faut cependant faire effectuer au miroir $M_{21}$ une translation l'amenant en position II, de façon à intercepter et à réfléchir le faisceau incident 15 et le faisceau 16 émergeant de l'objectif de projection $O_P$. La détection des ordres de diffraction s'effectue également dans le plan de Fourier $P_F$ par les moyens optoélectroniques $D_1$.

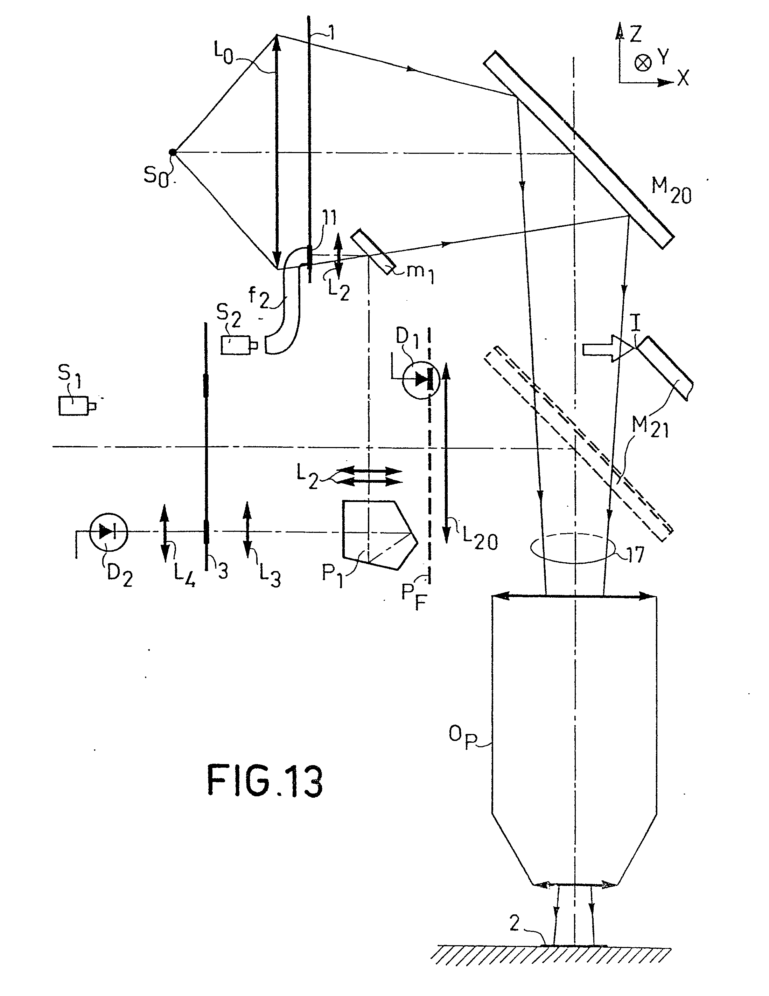

La figure 13 illustre la phase de projection (insolation), l'alignement étant atteint. Le miroir doit alors être recommuté en position I.

En ce qui concerne le miroir $M_{21}$, un arrêt précis suivant la direction Y n'est pas nécessaire. Seul le positionnement du miroir $M_{21}$ suivant les axes X et Z doit être assuré avec précision pour que l'image projetée sur la plaquette semi-conductrice 2 soit de bonne qualité. Typiquement, si l'on désire une précision de l'ordre de 0,1 micromètre sur la plaquette semi-conductrice 2, le positionnement du miroir doit être reproductible avec une précision angulaire de l'ordre de 0,2 secondes d'arc et une précision linéaire de 0,2 μm. Ces reproductibilités de positionnement sont compatibles avec l'utilisation des tables de translation disponibles dans les photorépéteurs de l'art connu, par exemple une table de translation du type à rouleaux croisés ou une table à coussin d'air. Cette table de translation n'a pas été représentée sur les figures 11 à 13.

Cette exigence étant remplie, la variante décrite au regard des figures 11 à 13 présente de nombreux avantages :

— le miroir $M_{21}$ peut également jouer le rôle d'obturateur pour l'exposition. En outre, la qualité de surface de ce miroir peut être moindre que celle exigée pour la lame $M_{11}$ mise en œuvre

pour la première variante de réalisation (figures 1 à 3) ;

— l'optique de compensation se réduit à une seule lentille $L_{20}$ car elle n'intervient que pour corriger la différence de longueur d'ondes entre les sources utilisées pour l'alignement et la projection. Cette optique de compensation n'est nécessaire que si l'on utilise deux longueurs d'onde distinctes ;

— on n'introduit pas d'aberrations pendant la phase d'alignement comme c'est le cas pour la première variante de l'invention, car le faisceau d'alignement doit traverser la lame $M_{11}$ de la figure 1.

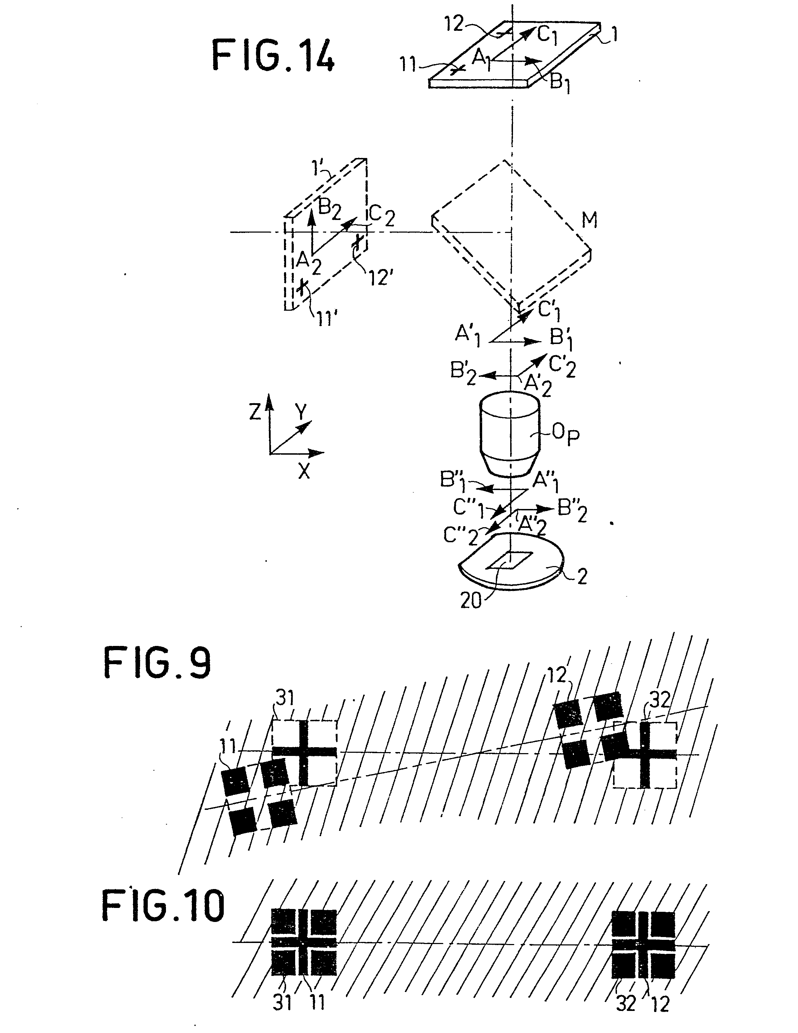

Bien que présentant de nombreux avantages, les deux variantes du système optique d'alignement qui viennent d'être décrites ne peuvent être mises en œuvre que dans un photorépéteur présentant une structure originale, différente de la majorité des photorépéteurs de l'art connu. Notamment, lors de la phase finale d'insolation de la plaquette semiconductrice, le faisceau de projection est replié sur lui-même par un miroir de renvoi : $M_{11}$ sur la figure 3 et $M_{20}$ sur la figure 13. Cette disposition permet d'obtenir une meilleure compacité du photorépéteur. Cependant, le réticule 1 portant le motif à projeter 10 n'est pas compatible dans ce cas avec les réticules utilisés sur les photorépéteurs de l'art connu, ce, de part la présence du miroir de renvoi. Ce phénomène est illustré par la figure 14.

En projection directe, c'est-à-dire sans miroir de renvoi M, un dièdre $A_1$ $B_1$ $C_1$ porté par un réticule 1 (sur lequel on a fait également figurer les repères d'alignement 11 et 12) sera projeté sur la plaquette semi-conductrice selon la configuration représentée sur la figure par le dièdre $A''_1$ $B''_1$ $C''_1$ après passage dans l'objectif de projection $O_P$. Sur la figure 14 est également représentée la position de ce dièdre $A'_1$, $B'_1$, $C'_1$ à l'entrée de l'objectif $O_P$.

Par contre, un dièdre $A_2$ $B_2$ $C_2$ porté par un réticule 1' (portant également des repères d'alignement 11' et 12') va être réfléchi par un miroir de renvoi M et se retrouver selon la configuration du dièdre $A'_2$ $B'_2$ $C'_2$ à l'entrée de l'objectif de projection $O_P$. A la sortie de l'objectif de projection, la position du dièdre est $A''_2$ $B''_2$ $C''_2$. Cette figure illustre clairement la non-compatibilité des systèmes d'alignement selon les deux variantes qui viennent d'être décrits.

Une troisième variante d'exécution d'un système optique d'alignement selon l'invention, sauvegardant cette compatibilité, va être décrite en relation avec la figure 15. Sur cette figure on retrouve les principaux éléments des deux variantes précédentes. Selon cette variante, le transfert des motifs 10 à projeter en 20 sur la plaquette semi-conductrice 2 s'effectue directement, c'est-à-dire sans miroir de renvoi. Le plan du réticule 1 est parallèle au plan de référence XY. Il en est de même du plan du réticule 3 portant les références liées à la machine. Dans un mode préférentiel d'exécution, ces deux réticules 1 et 3 peuvent être coplanaires.

La figure 15 illustre plus particulièrement la première phase de l'alignement, c'est-à-dire l'alignement l'un par rapport à l'autre des couples de repères de référence respectivement 31-32 et 11-12. Contrairement aux figures 2 et 12, dans un but d'illustration de la réversabilité du processus, le repère 31 (et également le repère 32) est éclairé par la source $S_2$ via la fibre optique $f_2$ et les moyens optoélectroniques de détection $D_2$-$L_4$ sont placés au regard du repère 11 (il en est de même pour le repère 12).

Pendant la seconde phase d'alignement, la partie éclairée des réseaux 33 et 34 va être projetée sur les réseaux correspondants 21 et 22 portée par la plaquette semi-conductrice, 2, ce, au travers d'un système optique comprenant les lentilles $L_{30}$ et $L_{31}$, l'objectif de projection $O_P$ et deux miroirs de renvoi $M_{30}$ et $M_{31}$. Comme pour la seconde variante décrite au regard des figures 11 à 13, le miroir $M_{31}$ doit être commutable entre deux positions I et II. Dans l'exemple de la figure 15, la commutation s'effectue suivant une direction parallèle à l'axe de référence Y. La position II correspond à la position d'alignement, la position I correspondant à celle d'exposition.

L'optique de correction, figurée par les lentilles $L_{30}$ et $L_{31}$ est telle qu'elle permet la mise au point sur la plaquette semi-conductrice 2 à la longueur d'onde de l'alignement, l'objectif $O_P$ étant corrigé pour la longueur d'onde utilisée pour le transfert. Cette optique de correction peut également être calculée pour que le plan comportant les références liées à la machine soit équivalent au plan du réticule.

Comme dans le cas de la première variante d'exécution, le miroir $M_{30}$ utilisé pendant la phase d'alignement des repères portés sur la plaquette semi-conductrice 2 par rapport aux repères liés à la machine 3 peut être partiellement réfléchissant à la longueur d'onde d'alignement pour pouvoir observer au point O le résultat de l'alignement.

L'invention n'est pas limitée aux réalisations qui viennent d'être décrites. En particulier, le système d'alignement selon l'invention peut être appliqué à tout dispositif utilisé pour positionner de façon précise, l'un par rapport à l'autre, deux objets sur lesquels sont portés au moins un motif d'alignement, cet alignement s'effectuant par rapport à un motif intermédiaire de référence porté par un support fixe.

**Revendications**

1. Système optique d'alignement l'un par rapport à l'autre d'un premier support mobile (1) et d'un second support mobile (2) au moyen d'un troisième support intermédiaire (3) lié de façon fixe audit système optique et formant référence, via l'utilisiation de trois motifs d'alignement (11-12, 21-22, 31-32/33-34) portés respectivement par lesdits trois supports (1, 2, 3), ledit système englobant :

a) des premiers moyens pour assurer l'alignement optique dudit premier support mobile (1) par rapport audit troisième support fixe (3), comprenant :

— un premier motif d'alignement (11, 12) porté par ledit premier support mobile (1), comprenant un couple de repères d'alignement (11, 12) disposés sur un axe (Y1) et distants l'un de l'autre d'une longueur déterminée, chaque repère comportant au moins deux zones de densité optique différente,

— un troisième motif d'alignement (31-32, 33-34) porté par ledit troisième support fixe (3), comprenant un premier couple de repères d'alignement (31, 32) optiquement complémentaires des repères (11, 12) du premier motif, disposés sur un axe (Y3) et distants l'un de l'autre de la même longueur déterminée que celle séparant les repères du premier motif,

— des premiers moyens pour projeter optiquement l'un de ces couples de repères d'alignement sur l'autre, comprenant une première source d'énergie radiante (S2) pour illuminer les repères d'un desdits couples, et des premiers moyens optiques (L1-L3, m1, p1), de grandissement +1, pour conjuguer optiquement lesdits couples, et

— des premiers moyens optoélectroniques (D2) pour détecter la coïncidence de ladite projection optique de l'un desdits couples sur l'autre, et

b) des seconds moyens pour assurer l'alignement optique dudit second support mobile (2) par rapport audit troisième support fixe (3), comprenant :

— un deuxième motif d'alignement (21, 22) porté par ledit second support mobile (2), comprenant un couple de réseaux optiques (21, 22) formant des repères d'alignement disposés respectivement sur deux axes orthogonaux ($X_1$, $Y_4$), éloignés d'une première, respectivement, seconde distance du point d'intersection des deux axes orthogonaux,

— un second couple de repères d'alignement (33, 34) également porté par ledit troisième motif d'alignement, constitué par deux réseaux optiques (33, 34) complémentaires des réseaux (21, 22) du deuxième motif, ces réseaux (33, 34) étant disposés le long de deux axes orthogonaux ($Y_2$, $Z_2$) ; et les réseaux optiques (21-22, 33-34) des deuxième et troisième motifs étant constitués chacun d'une suite de traits parallèles dont la largeur et la distribution spatiale suivant une première direction (C) sont déterminées par un code de répartition particulier, et les traits des réseaux optiques (21, 22) du second motif étant en outre interrompus périodiquement suivant une seconde direction (R) pour former un réseau optique à pas constants suivant cette direction,

— des seconds moyens pour projeter optiquement, selon un grandissement déterminé, une partie prédéterminée (35, 36) desdits réseaux optiques (33, 34) dudit troisième motif sur les réseaux optiques correspondants (21, 22) dudit deuxième motif, comprenant une seconde source d'énergie radiante monochromatique (S1) pour illuminer lesdites parties prédéterminées (35, 36) à projeter desdits réseaux optiques (33, 34) dudit troisième motif, en délimitant deux fenêtres d'éclairement (35, 36) de surface homothétique à la surface des réseaux (21, 22) du deuxième motif dans le rapport inverse du grandissement déterminé, lesdites fenêtres étant situées à une troisième respectivement quatrième distance du point d'intersection des deux axes orthogonaux ($Y_2$, $Z_2$), et le rapport commun entre les première et troisième distances et les deuxième et quatrième distances étant égal au grandissement déterminé ; et des seconds moyens optiques ($O_p$) ayant ledit grandissement déterminé pour conjuguer optiquement lesdites parties prédéterminées (35, 36) desdits réseaux optiques (33, 34) dudit troisième motif et lesdits réseaux optiques (21, 22) dudit deuxième motif, ladite projection étant destinée à produire des ordres de diffraction suivant les première et seconde directions (C, R), dont l'intensité lumineuse est représentative de l'état d'alignement atteint, et

— des seconds moyens optoélectroniques (D1) pour détecter l'intensité d'une partie prédéterminée des ordres de diffraction suivant la seconde direction (R), l'intensité détectée passant par un maximum et l'alignement précis étant obtenu lorsque la corrélation spatiale des réseaux optiques (21, 22) du deuxième motif et de la projection de l'image de ladite partie prédéterminée (35, 36) des réseaux optiques (33, 34) du troisième motif sur le deuxième motif est maximale, de sorte que les alignements optiques respectifs desdits premier (1) et second (2) supports mobiles par rapport audit troisième support fixe (3) ainsi susceptibles d'être réalisés se traduisent par l'alignement optique automatique desdits premier et second supports mobiles l'un par rapport à l'autre.

2. Système selon la revendication 1, caractérisé en ce que les premiers moyens optiques d'un grandissement égal à +1 comprennent pour chaque repère d'alignement du premier motif à conjuguer optiquement avec ceux du troisième motif, un prisme ($P_1$) à double réflexion, un miroir ($m_1$) de renvoi et un nombre pair de lentilles convergentes ($L_1$-$L_3$), et en ce que la première source ($S_2$) est associée à des moyens optiques ($F_2$) concentrant l'énergie lumineuse sur les seuls repères d'alignement (11, 12).

3. Système selon la revendication 1, caractérisé en ce que le support intermédiaire (3) lié de façon fixe au système optique est en matériau transparent sur lequel sont inscrits lesdits deux réseaux optiques (33, 34) complémentaires, ces réseaux étant constitués par des traits définissant des zones alternées différenciées par leur coefficient de transmission ; et en ce que le second support mobile (2) est en matériau réfléchissant sur lequel sont gravés ledit couple de réseaux optiques (21, 22) formant repères d'alignement, ces réseaux étant constitués par des traits définissant des zones alternées différenciées en épaisseur ou en nature.

4. Système selon l'une quelconque des revendications 1 à 3, caractérisé en ce que les premier (11, 12) et troisième motifs (31-32, 33-34) sont dans des plans parallèles et en ce que le deuxième motif (21-22) est dans un plan orthogonal au plan des premier et troisième motifs.

5. Système selon la revendication 1, caractérisé en ce que les seconds moyens optiques à grandissement déterminé comprennent un objectif de projection ($O_p$) au grandissement déterminé et un miroir fixe ($M_{10}$) repliant de $\pi/2$ radians le faisceau de rayons utilisé pour l'alignement des troisième et deuxième motifs produit par ladite source monochromatique ($S_1$).

6. Système selon l'une quelconque des revendications 1 à 3, caractérisé en ce que les premier (11, 12) et troisième motifs (31-32, 33-34) sont dans un même plan et en ce que le deuxième motif (21-22) est dans un plan parallèle au plan des premier et troisième motifs.

7. Système selon la revendication 6, caractérisé en ce que les seconds moyens optiques de grandissement déterminé comprennent un objectif de projection ($O_p$) du grandissement déterminé, un miroir fixe ($M_{30}$) repliant une première fois de $\pi/2$ radians le faisceau de rayons utilisés pour l'alignement des troisième et second motifs produit par ladite source monochromatique et un miroir mobile ($M_{31}$) repliant une seconde fois de $\pi/2$ radians le faisceau de rayons ; le miroir mobile ($M_{31}$) étant commutable entre deux positions (I, II) dans un plan (XY) parallèle au plan du deuxième motif et suivant une direction (Y) parallèle à l'une des première ou seconde directions (C, R).

8. Photorépéteur pour l'alignement d'une plaquette semi-conductrice (2) constituant ledit second support mobile selon la revendication 1 portant sur sa face supérieure une couche de résine photosensible et sur laquelle est inscrit ledit second motif d'alignement (21, 22) par rapport à au moins un réticule (1) constituant ledit premier support mobile selon la revendication 1 sur lequel est inscrit ledit second couple de repères d'alignement (33, 34), ainsi que d'autres motifs (10) à projeter sur la plaquette (2) ; photorépéteur caractérisé en ce qu'il comporte un système optique d'alignement selon l'une quelconque des revendications 1 à 7 et en ce que l'objectif de projection ($O_p$) au grandissement déterminé est utilisé alternativement pour la projection de l'image dudit second couple de repères d'alignement (33, 34) pendant des phases d'alignement et pour la projection sur la plaquette (2) en des endroits déterminés, de l'image des autres motifs (10) pendant des phases d'exposition.

9. Photorépéteur selon la revendication 8, caractérisé en ce qu'il comprend au moins une première source d'énergie lumineuse ($S_0$) d'une première longueur d'onde, activée pendant les phases d'exposition, et une seconde source d'énergie radiante constituant ladite seconde source d'énergie radiante ($S_1$) monochromatique selon la revendication 1, émettant sur une seconde longueur d'onde distincte de la première longueur d'onde activée pendant les phases d'alignement ; et en ce qu'il comprend, l'objectif de projection au grandissement déterminé ($O_p$) étant corrigé pour la première longueur d'onde, des moyens optiques ($L_{10}$, $L_{11}$) de correction de mise au point compensant l'écart de mise au point et de grandissement dû à l'utilisation de rayonnements de longueur d'ondes différentes.

10. Photorépéteur selon la revendication 9, caractérisé en ce qu'il comprend une seule source d'énergie radiante constituée par ladite source d'énergie radiante monochromatique ($S_1$) selon la revendication 1 utilisée alternativement pour l'alignement et l'exposition et en ce que pendant les phases d'alignement la source ($S_1$) est diaphragmée fortement pour obtenir un éclairement cohérent de très faible intensité.

11. Photorépéteur selon l'une quelconque des revendications 8 à 10, caractérisé en ce que les seconds moyens optiques de grandissement déterminé comprennent en outre un miroir partiellement transparent à la seconde longueur d'onde ($M_{11}$), le miroir ayant un coefficient de réflexion substantiellement égal à l'unité pour la première longueur d'onde.

**Claims**

1. An optical system for mutually aligning a first mobile support (1) and a second mobile support (2) by means of a third, intermediate support (3) which is rigidly attached to said optical system and constitutes a reference, by using three alignment patterns (11-12, 21-22, 31-32/33-34) which are borne by said three supports (1, 2, 3) respectively, said system including :

a) first means for optically aligning said first mobile support (1) with respect to said third fixed support (3), these means comprising :

— a first alignment pattern (11, 12) borne by said first mobile support (1) and bearing a pair of alignment marks (11, 12) which are disposed on an axis (Y1) and spaced from each other by a given length, each mark comprising at least two zones of different optical density,

— a third alignment pattern (31-32, 33-34) borne by said third fixed support (3) and bearing a first pair of alignment marks (31, 32) which are optically complementary to the marks (11, 12) of the first pattern, these marks being disposed on an axis (Y3) and spaced from each other by a length which is identical to the length between the marks of the first pattern,

— first means for optically projecting one of these pairs of alignment marks onto the other, comprising a first radiation energy source (S2) for illuminating the marks of one of these pairs, and first optical magnification means (L1-L3, m1, p1) of magnification +1 for optically combining said pairs, and

— first opto-electronic means (D2) for detecting the coincidence of said optical projection between said two pairs, and

b) second means for optically aligning said second mobile support (2) with respect to said third fixed support (3), said means comprising :

— a second alignment pattern (21, 22) borne by said second mobile support (2) and comprising a pair of optical networks (21, 22) which constitute alignment marks and which are disposed each on one of two orthogonal axes (X₁, Y₄) at a first and second distance respectively from the point of intersection of the two orthogonal axes,

— a second pair of alignment marks (33, 34), also borne by said third alignment pattern and constituted by two optical networks (33, 34) which are complementary to the networks (21, 22) of the second pattern, these networks (33, 34) being located on two orthogonal axes (Y₂, Z₂) ; the optical networks (21-22, 33-34) of the second and third pattern being each composed of a succession of parallel strokes whose width and spatial distribution along a first direction (C) are determined by a particular distribution code, the strokes of the optical network (21, 22) of the second pattern further being periodically interrupted along a second direction (R) so as to form an optical network with constant pitches in this direction,

— second means for optically projecting a predetermined part (35, 36) of said optical networks (33, 34) of said third pattern according to a given magnification onto the corresponding optical networks (21, 22) of said second pattern, these second means comprising a second source of monochromatic radiation energy (S1) for illuminating said predetermined parts (35, 36) of said optical networks (33, 34) of said third pattern which ought to be projected, by defining two illumination windows (35, 36) having the same area as the networks (21, 22) of the second pattern in the inverse ratio of said given magnification and being spaced by a third and fourth distance respectively from the point of intersection of the two orthogonal axes (Y₂, Z₂), the common ratio between the first and the third distance and between the second and fourth distance being equal to the given magnification, and second optical means (Oₚ) being provided which have said given magnification in order to conjugate optically said predetermined parts (35, 36) of said optical networks (33, 34) of said third pattern with said optical networks (21, 22) of said second pattern, said projection being conceived to produce diffraction orders along the first and second directions (C, R), the light intensity of which depends on the achieved alignment state, and

— second optoelectronic means (D1) for detecting the intensity of a predetermined part of the diffraction orders along the second direction (R), the detected intensity passing through a maximum and the precise alignment being achieved when the spatial correlation of the optical networks (21, 22) of the second pattern and the projection of the image of the predetermined part (35, 36) of the optical networks (33, 34) of the third pattern on the second pattern is maximum, in such a way, that the respective optical alignments which may thus be realized, of said first (1) and second (2) mobile supports with respect to the third fixed support (3) results in the automatic mutual optical alignment between said first and second mobile supports.

2. A system as claimed in claim 1, characterized in that the first optical means having a magnification of + 1 comprise, for each alignment mark of the pattern which ought to be optically conjugated with that of the second pattern, a double reflection prism (P₁), a reflection mirror (m₁) and an even number of converging lenses (L₁-L₃), and that the first source (S2) is associated to optical means (F₂) for concentrating the light energy on the alignment marks (11, 12) only.

3. A system as claimed in claim 1, characterized in that the intermediate support (3) which is rigidly connected to the optical system is made from a transparent material on which said two complementary optical networks (33, 34) are inscribed, these networks being composed of strokes defining alternate zones differentiated by their transmission coefficient, and that the second mobile support (2) is made from a reflecting material on which is etched said pair of optical networks (21, 22) forming alignment marks, these networks being constituted by strokes defining alternate zones differentiated by thickness or nature.

4. A system according to any one of claims 1 to 3, characterized in that the first (11, 12) and third patterns (31-32, 33-34) are disposed in mutually parallel planes, and that the second pattern (21, 22) is disposed in an orthogonal plane thereto.

5. A system according to claim 1, characterized in that the second optical means of given magnification comprise a projection objective having said given magnification, and a fixed mirror (M₁₀) reflecting back by π/2 the beam of rays used for aligning the third and second patterns and produced by said monochromatic source (S₁).

6. A system according to any one of claims 1 to 3, characterized in that the first and third patterns (11, 12 ; 31-32, 33-34) are disposed in one plane and that the second pattern (21, 22) is disposed in a plane parallel thereto.

7. A system according to claim 6, characterized in that the second optical means of given magnification comprise a projection objective (Oₚ) of said given magnification, a fixed mirror (M₃₀) reflecting back a first time by π/2 the beam of rays used for aligning the third and second patterns and produced by said monochromatic source ; and a mobile mirror (M₃₁) reflecting back a second time by π/2 the beam of rays, the mobile mirror (M₃₁) being switchable between two positions (I, II) in a plane (XY) parallel to the plane of the second pattern and in a direction (Y) parallel to one of the first and second directions (C, R).

8. A photorepeater device for aligning a semiconductor wafer (2) constituting said second mobile support according to claim 1, having on its upper face a layer of photosensitive resin, on which is inscribed said second alignment pattern (21, 22), with respect to at least one reticle (1) on which is inscribed said pair of alignment marks (33, 34) as well as other patterns (10) which ought to be projected onto said wafer (2), characterized in that it comprises an optical alignment system according to any one of claims 1 to 7, and that the projection objective ($O_p$) having a magnification + 1 is alternately employed for projecting the image of said second pair of alignment marks (33, 34) during the alignment phases, and for projecting the image of the other patterns (10) onto given locations of the wafer (2) during exposure phases.

9. A photorepeater device according to claim 8, characterized in that it comprises at least a first source of light energy ($S_0$) having a first wave length and being activated during the exposure phases, and a second source of radiation energy constituting said second source of monochromatic radiation energy ($S_1$) according to claim 1, having a second wavelength differing from the first wavelength and being activated during the alignment phases, and that, the projection objective ($O_p$) of the given magnification being corrected for the first wavelength, it comprises optical correction means ($L_{10}$, $L_{11}$) compensating for the focussing and the magnification deviation due to the use of radiation of different wavelength.

10. A photorepeater device according to claim 9, characterized in that it comprises a unique source of radiation energy constituted by said source ($S1$) of monochromatic radiation energy according to claim 1, which source is alternately employed for the alignment and for the exposure, and that the source is heavily diaphragmed during the alignment phases so as to obtain a coherent illumination of very low intensity.

11. A photorepeater device according to any one of claims 8 to 10, characterized in that the second optical means of given magnification further comprise a mirror ($M_{11}$) partially transparent at the second wavelength, this mirror having a reflection coefficient substantially equal to the unity for the first wavelength.

## Ansprüche

1. Optisches System zum gegenseitigen Ausrichten eines ersten, beweglichen Trägers (1) und eines zweiten, beweglichen Trägers (2) mittels eines dritten Zwischenträgers (3), der fest mit dem optischen System verbunden ist und eine Referenz bildet, mithilfe von drei Ausrichtmotiven (11-12, 21-22, 31-32/33-34), die je auf den drei Trägern (1, 2, 3) angeordnet sind, wobei das System umfaßt :

a) erste Mittel, um die optische Ausrichtung des ersten, beweglichen Trägers (1) bezüglich des dritten, festen Trägers (3) zu bewirken, die aufweisen :

— ein erstes Ausrichtmotiv (11, 12), das auf dem ersten, beweglichen Träger (1) angeordnet ist und ein Paar von Ausricht-Bezugsmarken (11, 12) aufweist, die auf einer Achse (Y1) angeordnet sind und voneinander einen bestimmten Abstand auf weisen, wobei jede Bezugsmarke mindestens zwei Zonen verschiedener optischer Dichte aufweist,

— ein drittes Ausrichtmotiv (31-32, 33-34), das auf dem dritten, festen Träger (3) angeordnet ist und ein erstes Paar von Ausricht-Bezugsmarken (31, 32) aufweist, die optisch komplementär zu den Bezugsmarken (11, 12) des ersten Motivs sind, auf einer Achse (Y3) angeordnet sind und voneinander denselben vorbestimmten Abstand aufweisen wie die Bezugsmarken des ersten Motivs,

— erste Mittel, um eines dieser Paare von Ausricht-Bezugsmarken optisch auf das andere zu projezieren, wobei die Mittel eine erste Strahlungs-Energiequelle (S2) zur Beleuchtung der Ausrichtmarken eines der Paare und erste optische Mittel (L1-L3, m1, p1) zur Vergrößerung + 1 umfassen, um diese Paare optisch zu konjugieren, und

— erste optoelektronische Mittel (D2), um die Koinzidenz der optischen Projektion eines der Paare auf das andere zu entdecken, und

b) zweite Mittel, um die optische Ausrichtung des zweiten, beweglichen Trägers (2) bezüglich des dritten, festen Trägers (3) zu bewirken, die aufweisen :

— ein zweites Ausrichtmotiv (21, 22), das auf dem zweiten, beweglichen Träger (2) angeordnet ist und ein Paar optischer Netze (21, 22) aufweist, die Ausricht-Bezugsmarken bilden, auf je einer von zwei zueinander orthogonalen Achsen ($X_1$, $Y_4$), und zwar in einem ersten bzw. zweiten Abstand vom Schnittpunkt der beiden orthogonalen Achsen liegen,

— ein zweites Paar von Ausrichtmarken (33, 34), das auch auf dem dritten Ausrichtmotiv sitzt und aus zwei optischen Netzen (33, 34) besteht, die zu den Netzen des zweiten Motivs (21, 22) komplementär sind und entlang von zwei zueinander orthogonalen Achsen ($Y_2$, $Z_2$) angeordnet sind, wobei die optischen Netze (21-22, 33-34) des zweiten und des dritten Motivs je aus einer Folge paralleler Linien bestehen, deren Breite und räumliche Verteilung in einer ersten Richtung (C) durch einen besonderen Verteilungskode bestimmt sind, und wobei die Linien der optischen Netze (21, 22) des zweiten Motivs Außerdem periodisch entlang einer zweiten Richtung (R) unterbrochen sind, um ein optisches Netz mit gleichmäßigen Abständen in dieser Richtung zu bilden,

— zweite Mittel, um einen vorbestimmten Teil (35, 36) dieser optischen Netze (33, 34) des zweiten Motivs in einer bestimmten Vergrößerung optisch auf die entsprechenden optischen Netze (21, 22) des zweiten Motivs zu projezieren, wobei diese Mittel eine zweite monochromatische Strahlungs-Energiequelle (S1) enthalten, um die zu projezierenden vorbestimmten Teile (35, 36) der optischen Netze (33, 34) des dritten Motivs zu beleuchten, indem zwei Beleuchtungsfenster gleicher Fläche wie die Fläche der Netze (21, 22) des zweiten Motivs im umgekehrten Verhältnis der bestimmten Vergrößerung abgegrenzt werden, wobei die Fenster in einem dritten bzw. vierten Abstand vom Schnittpunkt der beiden orthogonalen Achsen ($Y_2$, $Z_2$) sitzen und das gemeinsame Verhältnis zwischen den ersten und dritten und den zweiten und vierten Abständen gleich der bestimmten Vergrößerung ist, wobei die zweiten Mittel weiter zweite optische Mittel ($O_p$) aufweisen, deren Vergrößerung gleich der bestimmten Vergrößerung ist, um die vorbestimmten Teile (35, 36) der optischen Netze (33, 34) des dritten Motivs und die optischen Netze (21, 22) des zweiten Motivs miteinander zu konjugieren, wobei diese Projektion dazu bestimmt ist, Beugungsordnungen in der ersten und zweiten Richtung (C, R) zu erzeugen, deren Lichtstärke ein Maß für die erzielte Ausrichtung ist, und

— zweite optoelektronische Mittel (D1), um die Intensität eines vorbestimmten Teils der Beugungsordnungen in der zweiten Richtung (R) zu entdecken, wobei die entdeckte Lichtstärke einen Höchstwert durchläuft und somit die genaue Ausrichtung erzielt ist, wenn die räumliche Korrelation der optischen Netze (21, 22) des zweiten Motivs und der Projektion des Bildes des bestimmten Teils (35, 36) der optischen Netze (33, 34) des dritten Motivs auf das zweite Motiv einen Höchstwert erreicht, derart, daß die sich so ergebende optische Ausrichtung des ersten bzw. des zweiten, beweglichen Trägers (1, 2) jeweils bezüglich des dritten, festen Trägers (3) zu einer automatischen gegenseitigen optischen Ausrichtung des ersten und des zweiten, beweglichen Trägers führt.

2. System nach Anspruch 1, dadurch gekennzeichnet, daß die ersten optischen Mittel mit einer Vergrößerung von + 1 für jede Bezugsmarke des ersten mit dem dritten Motiv optisch zu konjugierenden Motivs ein Prisma ($P_1$) mit Doppelreflexion, einen Umlenkspiegel ($m_1$) und eine gerade Zahl von Sammellinsen ($L_1$-$L_3$) enthält, und daß die erste Quelle ($S_2$) optischen Mitteln zugeordnet ist, die die Lichtenergie ganz auf die Ausricht-Bezugsmarken (11, 12) konzentrieren.

3. System nach Anspruch 1, dadurch gekennzeichnet, daß der fest mit dem optischen System verbundene Zwischenträger aus einem durchsichtigen Material besteht, auf dem die beiden komplementären optischen Netze (33, 34) angeordnet sind, wobei diese Netze aus Strichen bestehen, die durch ihren Durchlaßkoeffizienten differenzierte abwechselnde Zonen definieren, und daß der zweite, bewegliche Träger (2) aus einem reflektierenden Material besteht, auf dem das Paar optischer Netze (21, 22), das die Ausrichtmarken bildet, eingraviert ist, wobei diese Netze aus Strichen bestehenm die durch die Dicke oder ihre Art differenzierte abwechselnde Zonen definieren.

4. System nach einem beliebigen der Ansprüche 1 bis 3, dadurch gekennzeichnet, daß das erste (11, 12) und das dritte Motiv (31-32, 33-34) in zueinander parallelen Ebenen liegen und daß das zweite Motiv (21-22) in einer zu den Ebenen des ersten und des dritten Motivs senkrechten Ebene liegt.

5. System nach Anspruch 1, dadurch gekennzeichnet, daß die zweiten optischen Mittel mit der bestimmten Vergrößerung ein Projektionsobjektiv ($O_p$) mit der bestimmten Vergrößerung sowie einen festen Spiegel ($M_{10}$) aufweisen, der das für die Ausrichtung des dritten Motivs mit dem zweiten Motiv verwendete und von der monochromatischen Lichtquelle ($S_1$) erzeugte Strahlenbündel um einen rechten Winkel umlenkt.

6. System nach einem beliebigen der Ansprüche 1 bis 3, dadurch gekennzeichnet, daß das erste Motiv (11, 12) in derselben Ebene liegt wie das dritte Motiv (31-32, 33-34) und daß das zweite Motiv (21-22) in einer zu Ebene des ersten und des dritten Motivs parallelen Ebene liegt.

7. System nach Anspruch 6, dadurch gekennzeichnet, daß die zweiten optischen Mittel mit der bestimmten Vergrößerung ein Projektionsobjektiv ($O_p$) mit der bestimmten Vergrößerung, einen festen Spiegel ($M_{30}$), der das für die Ausrichtung des dritten und des zweiten Motivs verwendete und von der monochromatischen Lichtquelle erzeugte Strahlenbündel ein ersten Mal um einen rechten Winkel umlenkt, und einen beweglichen Spiegel ($M_{31}$) aufweisen, der das Strahlenbündel erneut um einen rechten Winkel umlenkt, wobei der bewegliche Spiegel ($M_{31}$) zwischen zwei Stellungen (I, II) in einer zur Ebene des zweiten Motivs parallelen Ebene (XY) und in einer Richtung (Y) umklappbar ist, die parallel zur ersten (C) oder zweiten Richtung (R) verläuft.

8. Photorepetierer zur Ausrichtung eines Halbleiterplättchens (2), das den zweiten, beweglichen Träger nach Anspruch 1, bildet, und auf seiner Oberseite eine Schicht lichtempfindlichen Harzes trägt, auf der das zweite Ausrichtmotiv (21, 22) nach Anspruch 1 aufgezeichnet ist, bezüglich einer Fadenkreuzplatte (1), die den ersten, beweglichen Träger nach Anspruch 1 bildet und auf der das zweite Paar von Ausricht-Bezugsmarken (33, 34) sowie weitere auf das Plättchen (2) zu projezierende Motive (10) aufgezeichnet sind, dadurch gekennzeichnet, daß er ein optisches Ausrichtsystem nach einem beliebigen der Ansprüche 1 bis 7 enthält und daß das Projektionsobjektiv ($O_p$) mit der bestimmten Vergrößerung abwechselnd für die Projektion des zweiten Paares von Ausricht-Bezugsmarken (33, 34) während der Ausrichtphasen und für die Projektion des Bildes der anderen Motive (10) an bestimmten Stellen des Plättchens während der Belichtungsphasen verwendet wird.

9. Photorepetierer nach Anspruch 8, dadurch gekennzeichnet, daß er mindestens eine erste Lichtenergiequelle ($S_0$) einer ersten Wellenlänge, die während der Belichtungsphasen aktiviert wird, und eine während der Ausrichtphasen aktivierte Quelle von Strahlungsenergie aufweist, die die zweite, monochromatische Quelle ($S_1$) von Strahlungsenergie nach Anspruch 1 bildet und Licht einer zweiten von der ersten Wellenlänge unterschiedlichen Wellenlänge aussendet ; und daß er, dessen Projektionsobjektiv ($O_p$) mit der bestimmten Vergrößerung für die erste Wellenlänge korrigiert ist, optische Korrekturmittel ($L_{10}$, $L_{11}$) für die Kompensierung der Scharfeinstellung und der Vergrößerung aufgrund der Verwendung von Strahlungen unterschiedlicher Wellenlängen aufweist.

10. Photorepetierer nach Anspruch 9, dadurch gekennzeichnet, daß er eine einzige Quelle von Strahlungsenergie aufweist, die von der monochromatischen Quelle von Strahlungsenergie ($S_1$) nach Anspruch 1 gebildet wird und die abwechselnd für die Ausrichtung und die Belichtung verwendet wird, und daß die Quelle ($S_1$) während der Ausrichtphasen stark abgeblendet wird, um eine kohärente Beleuchtung von sehr geringer Intensität zu bilden.

11. Photorepetierer nach einem beliebigen der Ansprüche 8 bis 10, dadurch gekennzeichnet, daß die zweiten optischen Mittel mit der bestimmten Vergrößerung außerdem einen für die zweite Wellenlänge teiltransparenten Spiegel ($M_{11}$) aufweisen, dessen Reflexionskoeffizient für die erste Wellenlänge im wesentlichen gleich eins ist.

# FIG.1

FIG.2

FIG.3

FIG.4

FIG.5

FIG.6

4

FIG.7

0 030 878

0 3 6 9 12 μm

# FIG. 8

FIG.11

FIG.12

FIG.13

FIG.14

FIG.9

FIG.10

FIG.15